Europäisches Patentamt

European Patent Office

Office européen des brevets

(19)

(11) Veröffentlichungsnummer: **0 424 798 A2**

(12) **EUROPÄISCHE PATENTANMELDUNG**

(21) Anmeldenummer: **90119966.1**

(22) Anmeldetag: **18.10.90**

(51) Int. Cl.⁵: **H05K 3/42**

(30) Priorität: 27.10.89 DE 3935831

(43) Veröffentlichungstag der Anmeldung:
02.05.91 Patentblatt 91/18

(84) Benannte Vertragsstaaten:
AT BE CH DE ES FR GB IT LI NL SE

(71) Anmelder: **HANS HÖLLMÜLLER
MASCHINENBAU GMBH & CO.
Kappstrasse 69
W-7033 Herrenberg(DE)**

(72) Erfinder: **Kraiss, Niko**

Stuttgarter Strasse 44
W-7032 Sindelfingen(DE)
Erfinder: **Haas, Rainer**
Filsstrasse 6
W-7033 Herrenberg(DE)
Erfinder: **Renz, Werner**
Bahnhofstrasse 7
W-7530 Pforzheim(DE)

(74) Vertreter: **Ostertag, Ulrich et al
Patentanwälte Dr. Ulrich Ostertag Dr.
Reinhard Ostertag Eibenweg 10
W-7000 Stuttgart 70(DE)**

(54) **Anlage zur Herstellung von durchkontaktierten Leiterplatten und Multilayern.**

(57) Eine Anlage zur Herstellung von durchkontaktierten Leiterplatten oder Multilayern umfaßt vier Moduln (1, 11, 16, 21), durch welche die zu behandelnden Gegenstände (3) im horizontalen, kontinuierlichen Durchlaufverfahren hindurchgeführt werden. Im ersten Modul (1) werden die zu beschichtenden Flächen in einer alkalischen, wässrigen Lösung konditioniert. Im zweiten Modul (11) erfolgt eine oxidative Vorbehandlung der zu beschichtenden Flächen. Im dritten Modul (16) wird eine Schicht organischer Monomere auf den zu beschichtenden Flächen abgeschieden. Im vierten Modul (21) schließlich werden die angeschiedenen Monomere zu einer elektrisch leitfähigen Schicht polymerisiert. Die so behandelten, an den Mantelflächen der Bohrlöcher elektrisch leitfähig gemachten Leiterplatten bzw. Multilayer (3) werden dann einer Metallisierung der Mantelflächen der Bohrlöcher zugeführt.

FIG.1

# ANLAGE ZUR HERSTELLUNG VON DURCHKONTAKTIERTEN LEITERPLATTEN UND MULTILAYERN

Die Erfindung betrifft eine Anlage zur Herstellung von durchkontaktierten Leiterplatten oder Multilayern, in welcher zur Erzielung einer elektrisch leitfähigen Schicht auf den Mantelflächen von Bohrlöchern die folgenden chemisch/physikalischen Prozesse durchgeführt werden:

a) Konditionierung der zu beschichtenden Flächen in einer alkalischen, wässrigen Lösung eines organischen Lösungsmittels;

b) oxidative Vorbehandlung der zu beschichtenden Flächen in einer oxidierenden Behandlungsflüssigkeit, vorzugsweise einer alkalischen Permanganatlösung;

c) Abscheiden einer Schicht organischer Monomere auf den zu beschichtenden Flächen aus einer wässrigen, ein organisches Lösungsmittel enthaltenden Lösung dieser Monomere;

d) Polymerisation der abgeschiedenen Monomere zu einer elektrisch leitfähigen Schicht in einer sauren Behandlungsflüssigkeit.

In jüngster Zeit werden zunehmend zur Erzielung höherer Schaltungsdichten beide Seiten elektronischer Leiterplatten mit Leitungsmustern belegt, die dann über Bohrungslöcher, deren Mantelfläche elektrisch leitend gemacht wird, miteinander in Verbindung gebracht werden. Man spricht in diesem Falle von "durchkontaktierten" Leiterplatten. Dieses Konzept wird auch auf mehrschichtige Strukturen ausgedehnt, bei denen also mehr als zwei auf gegenüberliegenden Seiten eines isolierenden Trägers angeordnete Leitungsmuster über Bohrlöcher elektrisch miteinander verbunden werden. In diesem Falle spricht man von durchkontaktierten Multilayern. Zur sprachlichen Vereinfachung wird jedoch nachfolgend ausschließlich von "Leiterplatten" gesprochen, wobei stillschweigend "Multilayer" mit einbezogen sein sollen.

In der industriellen Praxis werden durchkontaktierte Leiterplatten bisher fast ausschließlich nach dem Verfahren der "außenstromlosen Verkupferung" hergestellt. Dieses Verfahren beinhaltet nach der Reinigung und sogenannten Konditionierung des Substrates eine Behandlung in einer Edelmetall-Katalysatorlösung, aus welcher die Leiterplatten dann in das eigentliche stromlose Kupferbad verbracht werden. Derartige stromlose Kupferbäder enthalten Komplexbildner und üblicherweise Formaldehyd. Der Einsatz der Edelmetallkatalysatoren ist jedoch ebenso wie der der Komplexbildner und Formaldehyde aus Umweltgründen wenig erwünscht. Darüber hinaus ist die Wartung und die Badüberwachung des außenstromlosen Verkupferungsverfahrens aufwendig und kompliziert. Auch bei sorgfältigem Arbeiten droht immer wieder die Gefahr, daß eines der Bäder unbeabsichtigt "ausfällt".

Aus diesem Grunde wurde eine Anlage der eingangs genannten Art entwickelt. Sie ist in der DE-PS 38 06 884 beschrieben. In ihr wird die erste elektrische Leitfähigkeit auf den Mantelflächen der Bohrlöcher nicht mehr durch eine Metallisierung bzw. Verkupferung sondern durch einen elektrisch leitenden Polymerfilm erzielt. Dieser elektrisch leitende Polymerfilm eignet sich dann zur nachfolgenden Metallisierung mit Kupfer, beispielsweise in eiem galvanischen Bad. Dieses Verfahren vermeidet nicht nur die unerwünschten Edelmetallkatalysatoren, Formaldehyd und Komplexbildner; darüber hinaus ist auch die Durchführung des Verfahrens erheblich unproblematischer. Das bekannt Verfahren wurde jedoch bisher im wesentlichen nur labormäßig im Tauchverfahren ausgeführt. Es eignet sich in dieser Weise noch nicht für die Massenfertigung.

Aufgabe der vorliegenden Erfindung ist es, eine Anlage der eingangs genannten Art so auszugestalten, daß in der industriellen Produktion hohe Stückzahlen erzielt werden können.

Diese Aufgabe wird erfindungsgemäß dadurch gelöst, daß

e) für jeden Prozeß a bis d ein gesonderter Modul vorgesehen ist, durch welchen die Leiterplatten auf einem Försystem in einem horizontalen Durchlaufverfahren der Reihe nach hindurchgeführt werden, wobei

f) der Bewegungsweg der Leiterplatten innerhalb der Moduln zumindest teilweise unterhalb des Spiegels der dort eingesetzten Behandlungsflüssigkeit verläuft.

Dabei sind an und für sich in der industriellen Fertigung von Leiterplatten für andere Aufgaben modulartig aufgebaute Anlagen bekannt, durch welche die Leiterplatten im horizontalen Durchlaufverfahren auf einem Fördersystem hindurchbewegt werden. Erfindungsgemäß wird also in erster Linie das aus der DE-PS 38 06 884 bekannte Verfahren in eine kontinuierliches Durchlaufverfahren umgesetzt. Daß dies möglich ist, ist jedoch keineswegs selbstverständlich. Dabei muß berücksichtigt werden, daß das "Anwachsen" der ersten Monomerschicht auf der Wandung der Bohrlöcher ein dynamisch sehr delikater Prozeß ist. Die Vermutung liegt nahe, daß Relativbewegungen zwischen der Leiterplatte und der Behandlungsflüssigkeit in dieser Phase vermieden werden müssen, daß also tatsächlich die Leiterplatten während der Berührung mit der die Monomeren enthaltenden Lösung stillstehen müssen. Mit der Erfindung wurde erstmals gezeigt, daß diese Vermutung nicht zutreffend ist, daß also entgegen den Befürchtungen eine sorgfältig geführte Relativbewegung der Leiterplatten gegenüber der Behandlungsflüssigkeit dem Erfolg nicht nur nicht abträglich sondern sogar förderlich ist.

Allerdings können die aus dem stationären Tauchverfahren (DE-PS 38 06 884) gewonnenen Erkenntnisse keinesfalls eins-zu-eins in ein kontinuierliches Durchlaufverfahren umgesetzt werden. Diese Umsetzung erfordert vielmehr eine Vielzahl von minutiös einzuhaltenden Einzelmaßnahmen, ohne die der Erfolg möglicherweise in Frage steht. Das Herausfinden dieser Einzelmaßnahmen stellt einen sehr schwierigen Prozeß dar, wobei die Bedeutung nicht in jedem Falle sofort zu erkennen ist.

So wird beispielsweise nach einem Merkmal der Erfindung die Erzielung zufriedenstellender Ergebnisse dann erleichtert, wenn zwischen den aufeinanderfolgenden Moduln, in denen die Prozesse a, b, c ablaufen, jeweils ein Spülmodul geschaltet ist, in dem die Leiterplatten beidseits mit Spülwasser besprüht werden, wobei aber die Moduln in dem die Prozesse c und d ablaufen, mit ihrer Ausgabestation bzw. Eingabestation ohne Zwischenschaltung eines Spülmoduls direkt aneinander anstoßen. Die Verwendung von Spülmoduln zwischen aufeinanderfolgenden Behandlungsmoduln folgt aus der Erfahrung, die mit kontinuierlichen Durchlaufverfahren in anderen Herstellungsbereichen gemacht wurden. Daß aber zwischen den Moduln, in denen die zu beschichtenden Flächen mit Monomeren überzogen und die Monomere dann zu der elektrisch leitfähigen Schicht auspolymerisiert werden, ein Spülvorgang eher schädlich ist, war nicht ohne weiteres vorherzusehen.

Der Luftraum innerhalb der Moduln, in dem die Prozesse a bis d ablaufen, sollte absaugbar sein. Für den in der erfindungsgemäßen Anlage erzielten Erfolg ist es von außerordentlicher Bedeutung, daß die chemisch/physikalischen Vorgänge an den Leiterplatten nur in exakt definierter Weise einsetzen. Hierbei kann es schon schädlich sein, wenn nur mit einem Luftstrom verschleppte Tröpfchen oder Spritzer auf die Leiterplatte zu einem unkontrollierten Zeitpunkt treffen. Die Absaugung der verschiedenen Moduln vermeidet einen derartigen Tropfenflug weitgehend.

Besonders kritisch ist dabei ein Tropfenflug zwischen den beiden letzten Moduln der hier besprochenen Anlage. Diese sind, wie weiter oben schon erwähnt, vorzugsweise nicht durch eine Spülmaschine voneinander getrennt. Hier wird daher bevorzugt, daß der Luftraum in der Ausgabestation des Moduls, in dem Prozeß c abläuft, und der Luftraum in der Eingabestation des Moduls, in dem Prozeß d abläuft, mit Zuluft versorgbar sind. Diese Zuluft in den zwischengeschalteten Ausgabe- und Eingabestationen sorgt dann, gemeinsam mit dem Unterdruck in den abgesaugten Moduln dafür, daß ein Luftstrom nur von der Ausgabe- bzw. Eingabestation in den zugehörigen Modul zurück, niemals aber quer von Modul zu Modul verlaufen kann. In den Luftströmen enthaltene Tröpfchen können auf diese Weise nicht von Modul zu Modul gelangen.

Vorzugsweise sind die Spülmoduln als Kaskadenspülmaschinen mit mehreren getrennten Kammern, die vom Spülwasser entgegen der Bewegungsrichtung der Leiterplatten durchströmt werden, ausgebildet. In derartigen an und für sich bekannten Kaskadenspülmaschinen ist die Reinigungswirkung bei geringem Spülwasserverbrauch besonders gut.

Dem Modul, in dem der Prozeß d abläuft, sollte ein Spül-und Dekapierungsmodul nachgeschaltet sein, in welchem die Leiterplatten beidseits mit verdünnter Säure besprüht werden. Die Polymerisation, die im letzten Modul der Anlage abläuft, führt zu einem voluminösen, schwärzlichen Niederschlag, der sich von den metallischen Flächen der Leiterplatten leicht ablöst. Dieser Niederschlag muß aufgelöst und/oder abtransportiert werden, was vorzugsweise in diesem Spül- und Dekapierungsmodul geschieht.

Der Einsatz verschiedener Chemikalien wird dann minimiert, wenn die Behandlungsflüssigkeiten in dem Modul, in welchem der Prozeß d abläuft, und in dem Spül- und Dekapiermodul dieselbe ist. Hierfür eignet sich besonders fünfprozentige Schwefelsäure.

Bei gleicher Behandlungsflüssigkeit im letzten Modul der Anlage und in dem Spül- und Dekapierungsmodul bietet sich an, daß die Behandlungsflüssigkeit des Moduls, in welchem der Prozeß d abläuft, dem Spül- und Depakiermodul entnommen wird.

Der Verringerung des Chemikalienverbrauches dient auch diejenige Maßnahme, daß die Behandlungsflüssigkeit im Modul, in welchem der Prozeß b abläuft, über eine Elektrolysezelle, in welcher die Behandlungsflüssigkeit regeneriert wird, umwälzbar ist. Bei dieser Behandlungsflüssigkeit handelt es sich im allgemeinen um eine alkalische Permanganatlösung. Das Permanganat wird bekanntlich bei dem Oxidationsprozeß in eine niedrigere Oxidationsstufe zurückgeführt und kann elektrolytisch wieder aufoxidiert werden.

Wie oben bereits betont, sollten die Leiterplatten durch die verschiedenen Moduln zumindest bereichsweise unterhalb des Niveaus der dort befindlichen Behandlungsflüssigkeit hindurchgeführt werden. Hierzu empfiehlt sich eine Bauweise, bei welcher die Moduln, in denen die Prozesse a bis d ablaufen, jeweils ein Sumpf für die Behandlungsflüssigkeit und einen am Bewegungsweg der Leiterplatten angeordneten Behälter aufweisen, wobei jeweils eine Pumpe vorgesehen ist, die Behandlungsflüssigkeit derart aus dem Sumpf in den Behälter pumpt, daß sich in dem Behälter im dynamischen Gleichgewicht zwischen Zuförderung und überlaufen ein Niveau der Behandlungsflüssigkeit einstellt, das über dem Bewegungsweg der Leiterplatten liegt. Die Leiterplatten werden also nicht einfach durch eine stillstehende Behandlungsflüssigkeit hindurchgezogen sondern in Wechselwirkung mit einer Behandlungsflüssigkeit gebracht, die sich stetig erneuert.

Diese stetige Erneuerung bedeutet allerdings eine zusätzliche Relativbewegung zwischen Leiterplatte und Behandlungsflüssigkeit. Damit sich diese nicht schädlich auf den Erfolg auswirkt, ist nach einem weiteren Merkmal der Erfindung vorgesehen, daß die Behandlungsflüssigkeit über Verteilerrohre in den unteren Bereich des Behälters eingeleitet wird, und daß zwischen den Verteilerrohren und dem Bewegungsweg der Leiterplatten ein Abschirmblech angeordnet ist, dessen Ränder bis nahe an die seitlichen Wände des Behälters heranreichen. Turbulenzen, die durch die Einleitung von Behandlungsflüssigkeit in den Behälter entstehen könnten, spielen sich also im wesentlichen unterhalb des Abschirmbleches ab. Die Behandlungsflüssigkeit tritt dann durch die Spalte zwischen den Rändern des Abschirmbleches und den seitlichen Wänden des Behälters in einem kontrollierten Strömungsvorgang nach oben. Die Leiterplatten bewegen sich oberhalb der Abschirmbleche in einem ruhigen, definierten Strömungsbild.

An den Stellen, wo die Leiterplatten in den Behälter eintreten bzw. aus diesem austreten, können Walzenpaare und/oder Walzen/Rollenpaare angeordnet sein, wobei die Leiterplatten zwischen den Partnern der Paare hindurchgeführt werden. Unter "Walzen" werden hierbei solche Bauteile verstanden, deren axiale Erstreckung im wesentlichen über die gesmte Breite des Behälters verläuft. "Rollen" dagegen sind in axialer Richtung verhältnismäßig kurze Bauteile, von denen immer mehrere nebeneinander und in axialem Abstand über die Breite des Behälters hinweg verteilt sind. Ein Walzen/Rollenpaar enthält also auf einer Seite des Bewegungsweges der Leiterplatte eine sich über die gesamte Breite des Behälters erstreckende Walze, auf der gegenüberliegenden Seite des Bewegungsweges jedoch eine Mehrzahl von Rollen, die in Abstand voneinander angeordnet sind.

Die jeweils im Paar obenliegende Walze bzw. die obenliegenden Rollen dienen als Stauwalzen bzw. Staurollen, an denen sich die Behandlungsflüssigkeit bis über den Bewegungsweg der Leiterplatten hinaus stauen kann.

Wie bereits mehrfach erwähnt, ist die Erzielung definierter Strömungsverhältnisse in den einzelnen Behandlungsmoduln von großer Bedeutung, wenn ein reproduzierbares Ergebnis erhalten werden soll. Dabei kommt es möglicherweise nicht so sehr darauf an, wie diese Strömungsverhältnisse aussehen, als darauf, daß eben die Strömungsverhältnisse definiert sind. Dann nämlich lassen sich die Betriebsbedingungen an die definierten Strömungsverhältnisse anpassen, während bei nicht definierten Strömungen eine derartige Anpassung unmöglich ist. In diesem Zusammenhang hat sich als vorteilhaft herausgestellt, wenn am Eintritt der Leiterplatten in den Behälter ein Walzenpaar und am Austritt der Leiterplatten aus dem Behälter ein Walzen/Rollenpaar angeordnet ist. In dem Walzen/Rollenpaar sollen die Rollen der obere Partner sein. Aufgrund der Zwischenräume, die zwischen den einzelnen Rollen vorliegen, ist die Stauwirkung hier geringer als am gegenüberliegenden Ende, wo der obere Partner des Paares eine durchgehende Walze ist. Dies hat zur Folge, daß die zwischen dem Walzenpaar und dem Walzen/Rollenpaar gestaute Behandlungsflüssigkeit eine Hauptströmungsrichtung in Richtung auf das Walzen/ Rollenpaar erhält. Auf diese Weise wird also eine definierte Bewegung der Behandlungsflüssigkeit in diesem entscheidenden Bereich erzwungen.

Die Walzen im Walzenpaar am Eintritt in den Behälter sollten aus schlecht benetzbarem Material, vorzugsweise PTFE, bestehen. Auf diese Weise wird verhindert, daß die Walzen bei ihrer Drehung Behandlungsflüssigkeit aus dem Innenraum des Behälters in unkontrollierter Weise nach außen verschleppen oder gar verspritzen. Dies würde, wie bereits mehrfach erwähnt, zu unkontrollierten Kontakten zwischen den Leiterplatten und der Behandlungsflüssigkeit vor dem Zeitpunkt führen, zu dem dieser Kontakt dann tatsächlich erwünscht ist.

Einem oder mehreren Moduln, in welchen einer der Prozesse a bis d abläuft, kann ein Filter zugeordnet sein, über den die Behandlungsflüssigkeit dieses Moduls umgewälzt wird. Nach den oben Gesagten dürfte einleuchten, daß die Sauberkeit der Behandlungsflüssigkeit für das erzielte Ergebnis bedeutungsvoll ist. Diese Sauberkeit wird durch die kontinuierliche Umwälzung der Behandlungsflüssigkeit über das Filter gewährleistet.

Zur Verstärkung der Wechselwirkung zwischen Behandlungsflüssigkeit und Leiterplatte kann sich empfehlen, daß einem oder mehreren der Moduln, in denen einer der Prozesse a bis d abläuft, ein Ultraschallgebar zugeordnet ist, über den die Behandlungsflüssigkeit in diesem Modul mit Ultraschall beaufschlagbar ist.

Aus demselben Grund zeichnet sich eine Ausführungsform der Erfindung dadurch aus, daß einem oder mehreren der Moduln, in denen einer der Prozesse a bis d abläuft, eine Düse in der Nähe des Bewegungsweges der Leiterplatten zugeordnet ist, die eine Zwangsdurchflutung der Bohrlöcher mit Unterstützung von Druck und/oder Unterdruck herbeiführt.

Überraschenderweise hat sich herausgestellt, daß die Verweildauern der Leiterplatten in den einzelnen Behandlungsflüssigkeiten im kontinuierlichen Durchlaufverfahren sich erheblich von denjenigen unterscheiden, die bei dem bekannten Tauchverfahren für erforderlich gehalten wurden. Insgesamt läßt sich feststellen, daß eine erhebliche Verkürzung der Verweildauern in der erfindungsgemäßen Anlage erzielt werden kann. Bewährt hat sich, wenn die Verweildauern der Leiterplatten in den einzelnen Moduln wie folgt sind:

Modul, in dem der Prozeß a abläuft: ca. 14 s
Modul, in dem der Prozeß b abläuft: ca. 40 s
Modul, in dem der Prozeß c abläuft: ca. 40 s
Modul, in dem der Prozeß d abläuft: ca. 20 s

Diese Verweildauern werden in bekannter Weise durch gegenseitige Abstimmung der Geschwindigkeit des Fördersystemes und der Länge der einzelnen Moduln erzielt.

Von besonderer Wichtigkeit hat sich das Verhältnis der Verweildauern in den beiden letzten Moduln der erfindungsgemäßen Anlage herausgestellt. Unabhängig von der absoluten Größe dieser Verweildauern empfiehlt es sich, wenn der Modul, in dem der Prozeß d abläuft, etwa halb so lang ist wie der Modul, in welchem der Prozeß c abläuft. Dies bedeutet, daß die Verweildauer im letzten Modul immer etwa halb so lange wie die Verweildauer im vorletzten Modul sein sollte.

Ein Ausführungsbeispiel der Erfindung wird nachfolgend anhand der Zeichnung näher erläutert; es zeigen

Figur 1: schematisch die Seitenansicht einer Anlage zur Herstellung von durchkontaktierten Leiterplatten in dem Bereich, in dem die zur Metallisierung erforderliche leitende Schicht auf die Mantelfläche der Bohrungen aufgebracht wird;

Figur 2: in größerem Maßstab zwei der in Figur 1 dargestellten Moduln;

Figur 3: erneut in vergrößertem Maßstab den Bereich des Fördersystemes in einem der Moduln von Figur 2.

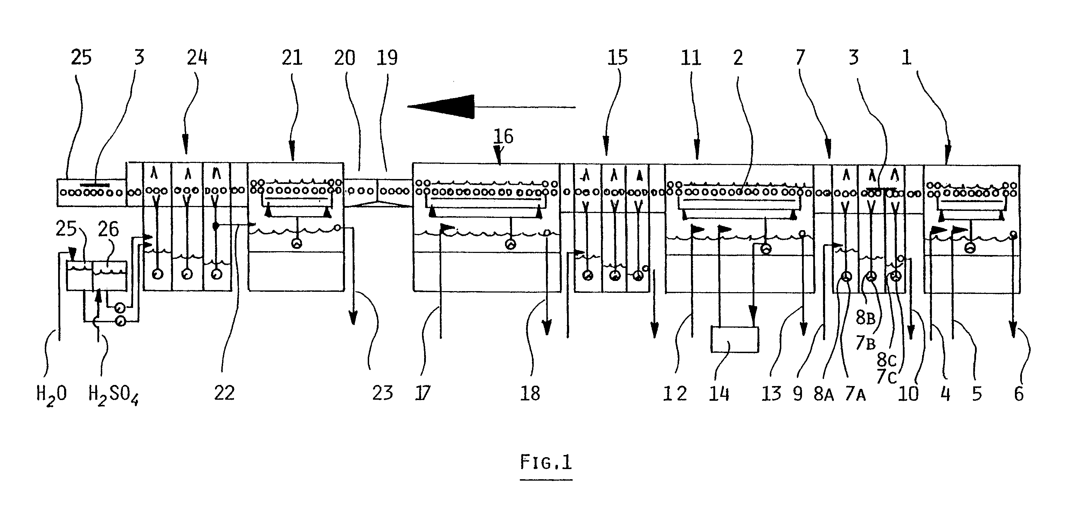

In Figur 1 ist ein Ausschnitt aus einer Anlage zur Herstellung von durchkontaktierten Leiterplatten dargestellt. Es handelt sich dabei um denjenigen Bereich, der sich mit de Erzielung einer leitfähigen Schicht auf den Mantel flächen der in den Leiterplatten eingebrachten Bohrungen befaßt. Diese erste Schicht dient dann dem weiteren außenstromlosen oder elektrolytisch-galvanischen Aufbau einer verhältnismäßig dicken metallischen (im allgemeinen Kupfer-) Schicht. Die entsprechenden Anlagenteils sind in Figur 1 nicht dargestellt; sie würden sich an der linken Seite anschließen. In der Fortsetzung der Gesamtanlage finden sich dann noch Maschinen, die sich mit der Ausbildung des Leitungsmusters befassen, so daß am Ende der Gesamtanlage Leiterplatten mit fertiggestelltem Leitermuster auf beiden Seiten austreten, wobei die Leitermuster auf beiden Seiten über verschiedene Bohrungen hinweg elektrisch miteinander verbunden (= "durchkontaktiert") sind.

Auch rechts von dem in Figur 1 gezeigten Anlagenbereich sind weitere Anlagenteile zu denken. In diesen werden die verschiedenen Bohrlöcher in die Leiterplatten eingebracht, die Bohrlöcher danach mechanisch entgratet (gebürstet); Verunreinigungen von den Mantelflächen der Bohrungen werden entfernt. Zusätzlich findet eine zur Entfernung von Oxidschichten und zur Haftungsverbesserung dienende erste Ätzung ("micro-etching") statt.

Die so vorbehandelten Leiterplatten treten an der rechten Seite des in Figur 1 dargestellten Anlagebereiches ein und durchwandern diese im Sinne des über der Anlage eingezeichneten Pfeiles.

Die Analge ist modulartig aufgebaut, d.h., sie ist aus einzelnen, standardisierten Maschinen zusammengesetzt, in denen jeweils ein Verfahrenschritt durchgeführt wird. Die Moduln sind so aufeinander abgestimmt, daß sie baukastenartig zu einer Gesamtanlage zusammengesetzt werden können. Jedes Modul stellt im Grundsatz eine in sich funktionsfähige Maschine dar und ist im allgemeinen auch selbständig handelsfähig.

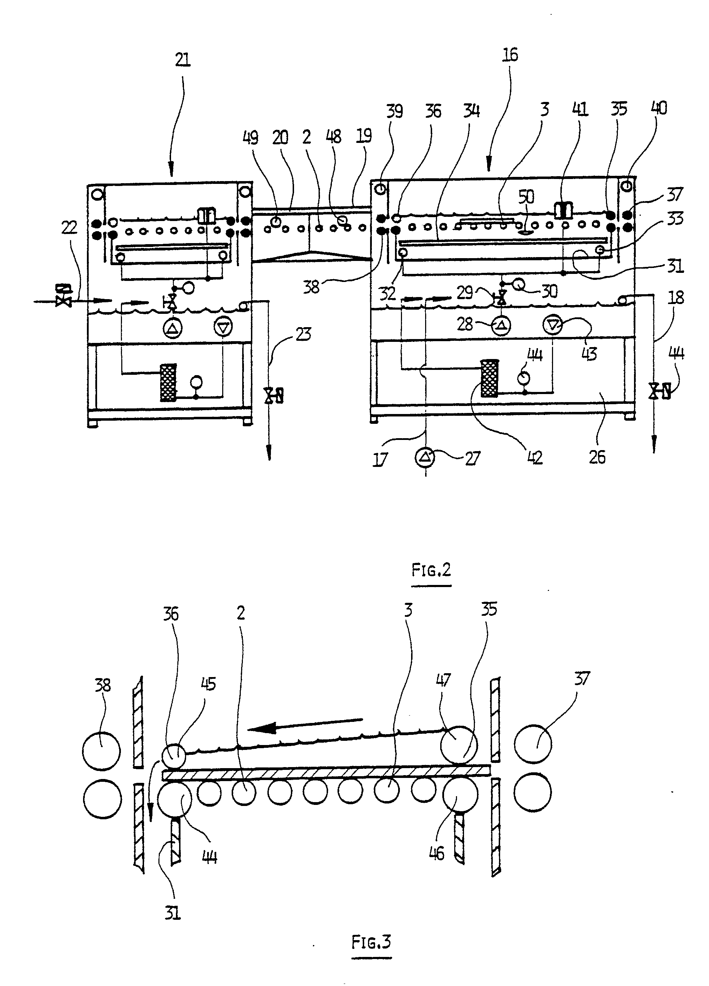

Zunächst wird die allgemeine Funktionsweise und der Aufbau der Ätzanlage ohne Eingehen auf konstruktive Einzelteile anhand der Figur 1 erläutert; der genauere Aufbau der einzelnen Moduln, soweit er im vorliegenden Zusammenhang von Interesse ist, wird weiter unten anhand der Figuren 2 und 3 besprochen.

In dem in Figur 1 am weitesten rechts gelegenen Modul 1 findet eine "Konditionierung" der vorbehandelten, also insbesondere mit Bohrlöchern versehenen, entgrateten und gereinigten Leiterplatten statt. Unter "Konditionierung" ist hier eine Behandlung mit einer wässrig-alkalischen Lösung eines organischen Lösungsmittels zu verstehen, welche insbesondere die Mantelflächen der Bohrlöcher in einen Zustand versetzt, bei welcher eine Haftung der in den nachfolgenden Moduln aufgebrachten Schicht gewährleistet ist. Wegen Einzelheiten der Chemie und der Verfahrensführung wird auf die bereits oben erwähnte DE = PS 38 06 884 Bezug genommen. Sofern also für das vorliegend angewandte Durchlaufverfahren keine besonderen Angaben gemacht werden, kann auf die Lehre der DE = PS 38 06 884 zurückgegriffen werden.

Die Leiterplatten werden durch die verschiedenen Moduln auf einem Rollenfördersystem 2 befördert, das an den verschiedenen Stoßstellen der einzelnen Moduln unmittelbar aneinander anschließt und entweder für jeden einzelnen Modul getrennt angetrieben oder auch von einer gemeinsamen Quelle durch entsprechende Kopplung zwischen den Moduln bewegt werden kann. In denjenigen Moduln, wie beispielsweise im Modul 1, wo ein chemisch/physikalischer Verfahrensschritt in einer Behandlungsflüssigkeit stattfindet, bewegt sich die Leiterplatte, die in Figur 1 mit dem Bezugszeichen 3 gekennzeichnet ist, unterhalb des entsprechenden Flüssigkeitsspiegels. Mit welchen konstruktiven Maßnahmen dies erreicht wird, wird weiter unten erläutert. über ein Leitung 4 wird NaOH, über die Leitung 5 das oben erwähnte organische Lösungsmittel dem Modul 1 zugeführt, über eine weitere Leitung 6 kann verbrauchte Behandlungsflüssigkeit dem Modul 1 entnommen werden.

Die in dem Modul 1 behandelten Leiterplatten 3 treten in ein Spülmodul 7 ein, wo sie auf dem Fördersystem 2 fortbewegt von oben und unten mit Spülwasser besprüht werden. Der Spülmodul 7 ist kaskadenartig aufgebaut. Hierzu ist er in drei Einzelabteile 7a bis 7c unterteilt, die jeweils einen getrennten Sumpf aufweisen. Jedem Sumpf ist eine eigenen Pumpe 8a, 8b, 8c zugeordnet, welche das Spülwasser zu Düsenstöcken entlang der Bewegungsbahn der Leiterplatten 3 hochpumpt. Frisches Wasser wird dem Spülmodul 7 über die Leitung 9 an demjenigen Ende zugeführt, an dem die gereinigten Leiterplatten 3 den Spülmodul 7 verlassen. Das Spülwasser gelangt aus dem Abteil 7a des Spülmoduls 7 um überlaufverfahren entgegen der Bewegungsrichtung de Leiterplatten 3 in die Abteile 7b und 7c und wird dnn über die Leitung 10 abgeführt. Mit diesem Gegenstromverfahren wird erreicht, daß die Leiterplatten 3 innerhalb des Spülmoduls 7 zuletzt mit dem saubersten Spülwasser in Berührung kommen.

Aus dem Spülmodul 7 werden die Leiterplatten 3 durch das Fördersystem 2 in ein Oxidationsmodul 11 eingebracht. In diesem werden insbesondere die Mantelflächen der Kontaktierungsbohrungen mit einer oxidierenden Flüssigkeit behandelt, ein Verfahrensschritt, der für die Haftung des in den nachfolgenden Moduln aufzubringenden elektrisch leitenden Filmes vn großer Bedeutung ist. Als Behandlungsflüssigkeit findet eine alkalische Kaliumpermanganatlösung Verwendung. Diese wird über die Leitung 12 zu- und über die Leitung 13 abgeführt. Außerdem wird die Behandlungsflüssigkeit innerhalb des Oxidationsmoduls 11 über eine Elektrolysezelle 14 umgewälzt und dabei laufend regeneriert, so daß der Chemikalienverbrauch innerhalb des Oxidations moduls 11 auf kleinstmöglichem Wert gehalten wird.

Die der Oxidationsbehandlung unterworfenen Leiterplatten 3 werden erneut durch ein Spülmodul 15 hindurchbewegt, dessen Aufbau dem Spülmodul 7 entspricht und der ebenfalls kaskadenartig im Gegenstromverfahren vom Spülwasser durchflossen wird. Insoweit kann auf die obige Beschreibung des Spülmoduls 7 Bezug genommen werden.

Aus dem Spülmodul 15 treten die Leiterplatten 3 in einen Modul 16 ein, der in Anlehnung an die früher verwendeten Verfahren "Katalysatormodul" genannt wird. Die Bezeichnung "Katalysator" ist beim vorliegenden Verfahren jedoch nicht ganz zutreffend. In dem Modul 16 findet vielmehr der erste Schritt auf dem Wege zu einer leitenden Schicht auf den Mantelflächen der Bohrlöcher statt.

Zu diesem Zwecks wird in den Katalysatormodul 16 über eine Leitung 17 eine Behandlungsflüssigkeit eingegeben, welche über eine Leitung 18 wieder entnommen werden kann. Bei der Behandlungsflüssigkeit handelt es sich um eine wässrige Lösung eines organischen Monomers mit einer gewissen Menge organischen Lösungsmittels, vorzugsweise eines hochsiedenden Alkohols. Über die Art der Monomere gibt die DE-PS 38 06 884 Auskunft. Die in dieser Behandlungsflüssigkeit enthaltenen Monomere lagern sich (unter anderem) an der Mantelfläche der Bohrlöcher ab und bilden so eine dünne, in diesem Zustand allerdings noch nicht leitfähige Schicht.

Ohne Zwischenschaltung eines weiteren Spülmoduls gelangen die Leiterplatten 3 aus der Ausgabestation 19 des Katalysatormoduls 16 in die Eingebestation 20 eines sogenannten "Fixierungsmoduls" 21. In dem Fixierungsmodul 21 findet die Polymerisierung der Monomere in der Schicht statt, die sich auf den Leiterplatten 3 im Modul 16 abgesetzt hat. Dabei bildet sich ein gleichmäßig leitender Polymerfilm, der auf den metallischen Flächen der Leiterplatten 3 allerdings nur wenig haftet und sich von diesen als dunkler Niederschlag ablöst. Die Mantelflächen der Bohrlöcher dagegen bleiben in der gewünschten Weise mit dem elektrisch leitenden Polymerfilm ausgekleidet.

Die "Fixierung" im Fixierungsmodul 21 findet in saurem Medium, ggf. unter Zusatz einer geringen Menge Oxidationsmittel, statt. Das saure Medium, im allgemeinen eine etwa fünfprozentige Schwefelsäure, wird dem Fixierungsmodul 21 über die Leitung 22 zugeführt und über die Leitung 23 entnommen.

Die Leiterplatten 3, welche den Fixierungsmodul 21 in Figur 1 nach links verlassen, gelangen in ein Spül- und Dekapierungsmodul 24, welcher dem Aufbau nach den Spülmoduln 7 und 15 entspricht. Bei der Behandlungsflüssigkeit handelt es sich hier allerdings nicht um Wasser sondern um fünfprozentige Schwefelsäure, welche ebenfalls kaskadenartig im Gegenstromverfahren durch die verschiedenen Kammern des Spül- und Dekapierungsmoduls 24 hindurchgeführt wird.

Die fünfprozentige Schwefelsäure entsteht durch Mischung in dem in Figur 1 am weitesten links gelegenen Abteil des Spül- und Dekapierungsmoduls 24 von Wasser und konzentrierter Schwefelsäure, die Tanks 25 und 26 entnommen werden.

Die soweit fertiggestellten und zur metallischen Durchkontaktierung vorbereiteten Leiterplatten 3 treten an der Ausgabestation 25 aus dem beschriebenen Anlagenbereich aus.

Einzelheiten der Behandlungsmoduln 1, 11, 16 und 21 werden nachfolgend anhand der Figuren 2 und 3 näher erläutert. Die Figur 2 zeigt in größerem Maßstab und mit mehr Einzelheiten den Katalysatormodul 16 und den hieran anschließenden Fixierungsmodul 21.

Wie bereits oben erwähnt, besteht ein wesentliches Merkmal bei der Behandlung der Leiterplatten 3 in den einzelnen Moduln darin, daß diese unterhalb des Spiegels der Behandlungsflüssigkeit, also vollständig in dieser eingetaucht, durch den entsprechende Modul hindurchbewegt werden. Dies wird durch eine Bauweise erreicht, die nunmehr anhand der Figur 2 für den Katalysatormodul 16 beschrieben ist, sich aber bei allen Moduln der Anlage in der gleichen Weise wiederfindet.

Der Modul 16 umfaßt im unteren Bereich einen Sumpf 26 für die Behandlungsflüssigkeit. Diesem wird die Behandlungsflüssigkeit mittels einer Pumpe 27 über die bereits oben erwähnte Leitung 17 zugeführt. Eine Pumpe 28 entnimmt dem Sumpf 26 Behandlungsflüssigkeit und leitet diese über ein Ventil 29 und einen Durchflußmengenmesser 30 in einen Behälter 31, der direkt unterhalb de Fördersystemes 2 angeordnet ist. Die Behandlungsflüssigkeit wird über zwei Verteilerrohre 32 und 33 in den Behälter 3 abgegeben. Diese befinden sich unterhalb eines Abschirmbleches 34, elches parallel zum Boden des Behälters 31 bzw. zum Fördersystem 2 verläuft. Das Abschirmblech 34 reicht mit seinen Rändern bis nahe an die Wände des Behältes 31 heran, so daß nur in diesen Randbereichen die Behandlungsflüssigkeit nach oben dringen kann. Dies hat zur Folge, daß sich die Leiterplatten 3 auf dem Fördersystem 2 oberhalb des Abschirmbleches 34 in einer Behandlungsflüssigkeit bewegen können, die durch die Zugabe über die Verteilerrohre 32, 33 praktisch nicht gestört ist, insbesondere keine Turbulenzen enthält.

An der in Figur 2 rechten Seite treten die Leiterplatten 3 in die in dem Behälter 31 aufgestaute Behandlungsflüssigkeit durch ein Walzenpaar 35 ein. Sie verlassen den Behälter 31 wieder über ein Walzen/Rollenpaar 36, dessen Funktion weiter unten anhand der Figur 3 näher erläutert wird. Das Walzenpaar 35 bzw. das Walzen/Rollenpaar 36 stellen ein definiertes "Leck" für den Behälter 31 dar, über welches aus dem Behälter 31 Behandlungsflüssigkeit in dem Maße entweichen kann, wie es durch die Pumpe 28 und über die Verteilerrohre 32 und 33 neu zugeführt wird. Dabei wird stationär ein Spiegel der Behandlungsflüssigkeit aufrecht erhalten, der oberhalb des Fördersystemes 2 und der auf diesen bewegten Leiterplatten 3 liegt.

Die durch den Spalt des Walzenpaares 35 bzw des Walzen/Rollenpaares 36 austretende Behandlungsflüssigkeit gelangt wieder in den Sumpf 26 des Moduls 16 zurück und wird hier erneut von der Pumpe 28 angesaugt.

Am Eingang und am Ausgang des Moduls 16 durchlaufen die Leiterplatten 3 jeweils ein Quetschwalzenpaar 37 bzw. 38, welches die Leiterplatten 3 von noch anhaftender Behandlungsflüssigkeit weitgehend befreit und so die Verschleppung von Behandlungsflüssigkeit in nachgeschaltete Moduln reduziert.

Die Gase und Dämpfe, die sich innerhalb des Moduls 16 entwickeln, werden über Leitungen 39, 40, deren Mündungsstellen in Figur 2 zu erkennen sind, abgesaugt.

In der Behandlungsflüssigkeit, die in dem Behälter 31 aufgestaut ist, befindet sich unterhalb des Bewegungsweges der Leiterplatten 3 ein Ultraschallgeber 41, durch den die Wirksamkeit der Behandlungsflüssigkeit erhöht werden kann. Außerdem ist hier eine eine Zwangsdurchströmung der Bohrlöcher bewirkende Düse 50 angeordnet, welche unter Druck und/oder Unterdruck Behandlungsflüssigkeit durch die Bohrlöcher hindurchpresst.

Im Sumpf 26 des Moduls 16 ist ein Filter 42 untergebracht, durch welches kontinuierlich die in dem Sumpf 26 befindliche Behandlungsflüssigkeit mittels einer Pumpe 43 umgewälzt wird. Ein Manometer 44 zeigt an, wenn das Filter 42 zugesetzt ist.

In Figur 2 ist schließlich die oben bereits erwähnte Leitung 18 dargestellt, über welche dem Modul 16 die Behandlungsflüssigkeit entnommen werden kann. In der Leitung 18 liegt wie in allen Leitungen, welche Behandlungsflüssigkeit den Moduln zu- bzw. abführen, ein Magnetventil 44. Die Steuerung dieses Magnetventiles 44 geschieht in bekannter Weise und ist nicht Gegenstand der vorliegenden Erfindung.

Oben wurde bereits darauf hingewiesen, daß die Eintrittsöffnung für die Leiterplatten 3 in den Behälter 31 des Moduls 16 durch ein Walzenpaar 35, die Austrittsöffnung dagegen von einem Walzen/Rollenpaar 36 gebildet wird. Der Grund für diese Maßnahme wird nunmehr anhand der Figur 3 näher erläutert.

In dieser sind "Walzen" zur Unterscheidung von "Rollen" mit einem etwas größeren Durchmesser dargestellt; grundsätzlich können jedoch Walzen und Rollen auch den gleichen Durchmesser aufweisen. Unter einer "Walze" wird hier ein Gegenstand verstanden, dessen axiale Dimension über die gesamte Breite des Behälters 31 reicht, während eine "Rolle" eine verhältnismäßig kleine axiale Abmessung aufweist. Wo in Figur 3 Rollen, also Kreise mit kleinem Durchmesser, dargestellt sind, ist dies also so zu verstehen, daß mehrere Rolen in Abstand zueinander hintereinander auf einer Achse angeordnet sind. Das Walzen/Rolenpaar 36 besteht also aus einer unteren, sich über die gesamte Dimension des Behälters 31 senkrecht zur Zeichenebene erstreckende Walze 44 und mehreren, ihr gegenüberstehenden koaxialen Rollen 45. Das Walzenpaar 35 dagegen besteht auseiner unteren Walze 46 und einer oberen, ebenfalls über die gesamte Breite des Behälters 31 verlaufenden Walze 47.

Da selbstverständlich die zwischen dem Walzenpaar 35 und dem Walzen/Rollenpaar 36 gestaute Flüssigkeit durch die zwischen den Rollen 45 befindlichen Zwischenräume verhältnismäßig leicht abströmen kann, bildet sich in dem Behälter 31 dynamisch ein Flüssigkeitsspiegel, der zum Walzen/rollenpaar 36 hin abfällt, so daß also der mit Behandlungsflüssigkeit gefüllte Raum oberhalb der Leiterplatten 3 keilförmig ist. Damit ist innerhalb dieses keilförmigen Raumes eine Hauptströmungsrichtung der Behandlungsflüssigkeit in Bewegungsrichtung der Leiterplatten 3, nämlich von den Walzenpaar 35 auf das Walzen/Rollenpaar 36 im Sinne des dargestellten Pfeiles vorgegeben. Durch diese Hauptströmungsrichtung ist gewährleistet, daß die Behandlungsflüssigkeit, die ja innerhalb des Behälters 31 dynamisch angestaut ist, sich in einer definierten Weise über die Leiterplatten 3 hinwegbewegt. Turbulenzen und unkontrollierte Bewegungsverhältnisse sind so weitgehend ausgeschlossen. Definierte Bewegungsverhältnisse sind zur Erzielung reproduzierbarer Ergebnisse unerläßlich. Eine Hauptbewegungsrichtung der Behandlungsflüssigkeit im Sinne des in Figur 3 dargestellten Pfeiles hat sich als besonders günstig herausgestellt; grundsätzlich wäre es aber auch möglich, durch geeignete entsprechende Maßnahme eine andere Hauptbewegungsrichtung herbeizufähren.

Die Walzen 46 und 47 im Walzenpaar 35 an der Eintrittsseite in den Behälter 31 sollten aus PTFE ("Teflon") oder einem anderen, von der Behandlungsflüssigkeit wenig benetzbaren Material bestehen. Hierdurch wird gewährleistet, daß keine Behandlungsflüssigkeit bei der Verdrehung der Walzen 46 und 47 aus dem Behälter 31 nach außen verschleppt wird, welche außerhalb des Behälters 31 auf die Leiterplatten 3 gelangen und so unkontrollierte Reaktionen hervorrufen könnte. Für die Erzielung optimaler Ergebnisse hat es sich als unerläßlich erwiesen, den Beginn der chemisch/physikalischen Behandlung der Leiterplatten 3 in den einzelnen Moduln zu einem exakt definierten Zeitpunkt und mit einer exakt definierten Stärke, gleichzeitig über die gesamte Breite der Leiterplatte 3 hinweg, sicherzustellen.

In den Behandlungsmoduln 1 und 11 sind allerdings derart hohe Anforderungen an die Behandlungsgüte nicht unbedingt erforderlich; hier kann sowohl an der Einlaufseite als auch an der Auslaufseite des jeweiligen Behälters 31 ein Walzenpaar vorgesehen werden, so daß also in diesen Moduln innerhalb der Behälter 31 keine Hauptbewegungsrichtung der Behandlungsflüssigkeit vorgesehen zu werden braucht.

In die Augabestation 19 des "Katalysatormoduls" 16 mündet eine Öffnung 48, über welche dem Innenraum der Ausgabetation 19 Zuluft zugeführt werden kann. In entsprechender Weise münet in die Eingabestation 20 des Fixierungsmoduls 21 eine Öffnung 49, über welche dem Innenraum de Eingabestation 20 Zuluft zugeführtwerden kann. Im Zusammenspiel zwischen dieser und dem unterdruck in den zugehörigen Moduln 16 und 21 wird sichergestellt, daß keine Sprühtropfen aus Behandlungsflüssigkeit des einen Moduls auf direktem Wege in den jeweils anderen Behandlungsmodul gelangen kann. Vielmehr sorgt ein dauernd von der Ausgabestation 19 in den Katalysatormodul 16 zurückführender Luftstrom und ein dauernd von der Eingabestation 20 in den Fixierungsmodul 21 zurückführender Luftstrom dafür, daß Dämpfe und Sprühtröpfchen, die aus diesen Moduln austreten, wieder in diese Leiterplatten 3 niemals in nicht kontrollierter Weise mit einer Behandlungsflüssigkeit in Berührung kommen können, was zu fehlerhaften Resultaten führen würde.

Die Verweilzeiten der Leiterplatten 3 in den verschiedenen Behandlungsmoduln sollte etwa wie folgt sein:
Konditioniermodul: ca. 14 s
Oxidationsmodul: ca. 40 s
Katalysatormodul: ca. 40 s
Fixierungsmodul: ca. 20 s.

Diese Verweilzeiten stimmen nicht mit denjenigen überein, die nach dem Stande der Technik für das Tauchverfahren ermittelt wurden. Alle verweilzeiten liegen erheblich kürzer, so daß also deutlich höhere Fertigngskapazitäten erzielt werden können. Außerdem ist die Verweilszeit im Fixierungsmodul 21 entgegen den Verhältnissen im Tauchverfahren nur etwa halb so groß wie die Verweilzeit im Katalysatormodul 16; dies spiegelt sich darin konstruktiv wider, daß der Fixierungsmodul 21 nur ungefähr die halbe Länge des Katalysatormoduls 16 aufweist.

**Ansprüche**

1. Anlage zur Herstellung von durchkontaktierten Leiterplatten oder Multilayern, in welcher zur Erzielung einer elektrisch leitfähigen Schicht auf den Mantelflächen von Bohrlöchern die folgenden chemisch/physikalischen Prozesse durchgeführt werden:

a) Konditionierung der zu beschichtenden Flächen in einer alkalischen, wässrigen Lösung eines organischen Lösungsmittels; b) oxidative Vorbehandlung der zu beschichtenden Flächen in einer oxidierenden Behandlungsflüssigkeit, vorzugsweise einer alkalischen Permanganatlösung; c) Abscheiden einer Schicht organischer Monomere auf den zu beschichtenden Flächen aus einer wässrigen, ein organisches Lösungsmittel enthaltenden Lösung dieser Monomere; d) Polymerisation der abgeschiedenen Monomere zu einer elektrisch leitfähigen Schicht in einer sauren Behandlungsflüssigkeit, dadurch gekennzeichnet, daß

e) für jeden Prozeß a - d ein gesonderter Modul (1, 2, 16, 21) vorgesehen ist, durch welchen die Leiterplatten (3) auf einem Fördersystem (2) in einem horizontalen Durchlaufverfahren der Reihe nach hindurchgeführt werden,
wobei

f) der Bewegungsweg der Leiterplatten (3) innerhalb der Moduln (1, 2, 16, 21) zumindest teilweise unterhalb des Spiegels der dort eingesetzten Behandlungsflüssigkeit verläuft.

2. Anlage nach Anspruch 1, dadurch gekennzeichnet, daß zwischen den aufeinanderfolgenden Moduln (1, 11, 16), in denen die Prozesse a, b, c ablaufen, jeweils ein Spülmodul (7, 15) geschaltet ist, in dem die Leiterplatten (3) beidseits mit Spülwasser besprüht werden, wobei aber die Moduln (16, 21), in denen die Prozesse c und d ablaufen, mit ihrer Ausgabestation (19) bzw. Eingabestation (20) ohne Zwischenschaltung eines Spülmoduls direkt aneinander anstoßen.

3. Anlage nach Anspruch 1 oder 2, dadurch gekennzeichnet, daß der Luftraum innerhalb der Moduln (1, 11, 16, 21), in dem die Prozesse a bis d ablaufen, absaugbar ist.

4. Anlage nach Anspruch 3 bei Rückbeziehung auf Anspruch 2, dadurch gekennzeichnet, daß der Luftraum in der Ausgabestation (19) des Moduls (16), in dem der Prozeß c abläuft, und der Luftraum in der Eingabestation (20) des Moduls (21), in dem Prozeß d abläuft, mit Zuluft versorgbar sind.

5. Anlage nach Anspruch 2, dadurch gekennzeichnet, daß die Spülmoduln (7, 15) als Kaskadenspülmaschine mit mehreren getrennten Kammern (7a, 7b, 7c), die vom Spülwasser entgegen der Bewegungsrichtung der Leiterplatte (3) durchströmt werden, ausgebildet sind.

6. Anlage nach einem der vorhergehenden Ansprüche, dadurch gekennzeichnet, daß dem Modul (21), in dem der Prozeß d abläuft, ein Spül- und Dekapierungsmodul (24) nachgeschaltet ist, in welchem die Leiterplatten (3) beidseits mit verdünnter Säure besprüht werden.

7. Anlage nach Anspruch 6, dadurch gekennzeichnet, daß die Behandlungsflüssigkeiten in dem Modul (21), in welchem der Prozeß d abläuft, und in dem Spül- und Dekapierungsmodul (24) dieselbe ist.

8. Anlage nach Anspruch 7, dadurch gekennzeichnet, daß die Behandlungsflüssigkeit des Moduls (21), in welchem der Prozeß d abläuft, dem Spül- und Dekapierungsmodul (24) entnommen wird.

9. Anlage nach Anspruch 1, dadurch gekennzeichnet, daß die Behandlungsflüssigkeit in dem Modul (11), in welchem der Prozeß b abläuft, über eine Elektrolysezelle (14), in welcher die Behandlungsflüssigkeit regeneriert wird, umwälzbar ist.

10. Anlage nach einem der vorhergehenden Ansprüche, dadurch gekennzeichnet, daß die Moduln (1, 11, 16, 21), in denen die Prozesse a bis d ablaufen, jeweils einen Sumpf (26) für die Behandlungsflüssigkeit und einen am Bewegungsweg der Leiterplatten (3) angeordneten Behälter (31) aufweisen, wobei jeweils eine Pumpe (28) vorgesehen ist, die Behandlungsflüssigkeit derart aus dem Sumpf (26) in den Behälter (31) pumpt, daß sich in dem Behälter (31) im dynamischen Gleichgewicht zwischen Zuförderung und überlaufen ein Niveau der Behandlungsflüssigkeit einstellt, das über dem Bewegungsweg der Leiterplatten (3) liegt.

11. Anlage nach Anspruch 10, dadurch gekennzeichnet, daß die Behandlungsflüssigkeit über Verteilerrohre (32, 33) in den unteren Bereich des Behälters (31) eingeleitet wird, und daß zwischen den Verteilerrohren (32, 33) und dem Bewegungsweg der Leiterplatten (3) ein Abschirmblech (34) angeordnet ist, dessen Ränder bis nahe an die seitlichen Wände des Behälters (31) heranreichen.

12. Anlage nach Anspruch 10, dadurch gekennzeichnet, daß an den Stellen, wo die Leiterplatten (3) in den Behälter (31) eintreten bzw. aus diesem austreten, Walzenpaare (35) und/oder Walzen/Rollenpaare (36) angeordnet sind, wobei die Leiterplatten (3) zwischen den Partnern der Paare (35, 36) hindurchgeführt werden.

13. Anlage nach Anspruch 12, dadurch gekennzeichnet, daß die Walzen (46, 47) im Walzenpaar (35) am Eintritt in den Behälter (31) aus schlecht benetzbarem Material, vorzugsweise PTFE, bestehen.

14. Anlage nach Anspruch 12, dadurch gekennzeichnet, daß am Eintritt der Leiterplatten (3) in den Behälter (31) ein Walzenpaar (35) und am Austritt der Leiterplatten (3) aus dem Behälter (31) ein Walzen/Rollenpaar (36) angeordnet ist.

15. Anlage nach einem der vorhergehenden Ansprüche, dadurch gekennzeichnet, daß einem oder mehreren der Moduln (1, 11, 16, 21), in welchen einer der Prozesse a bis d abläuft, ein Filter (42) zugeordnet ist, über den die Behandlungsflüssigkeit dieses Moduls (1, 11, 16, 21) umgewältzt wird.

16. Anlage nach einem der vorhergehenden Ansprüche, dadurch gekennzeichnet, daß einem oder mehreren der Moduln (1, 11, 16, 21), in welchen einer der Prozesse a bis d abläuft, ein Ultraschallgebar (41) zugeordnet ist, über den die Behandlungsflüssigkeit in diesem Modul (1, 11, 16, 21) mit Ultraschall beaufschlagbar ist.

17. Anlage nach einem der vorhergehenden Ansprüche, dadurch gekennzeichnet, daß einem oder mehreren der Moduln (1, 11, 16, 21), in welchen einer der Prozesse a bis d abläuft, eine Düse (50) in der Nähe des Bewegungsweges der Leiterplatten (3) zugeordnet ist, die eine Zwangsdurchflutung der Bohrlöcher mit Unterstützung von Druck- und/oder Unterdruck herbeiführen kann.

18. Anlage nach einem der vorhergehenden Ansprüche, dadurch gekennzeichnet, daß die Verweildauer der Leiterplatten (3) in den einzelnen Moduln (1, 11, 16, 21) wie folgt ist:

Modul (1), in dem der Prozeß a abläuft: ca. 14 s
Modul (11), in dem der Prozeß b abläuft: ca. 40 s
Modul (16), in dem der Prozeß c abläuft: ca. 40 s
Modul (21), in dem der Prozeß d abläuft: ca. 20 s.

19. Anlage nach einem der vorhergehenden Ansprüche, dadurch gekennzeichnet, daß der Modul (21), in dem der Prozeß d abläuft, etwa halb so lang ist wie der Modul (16), in dem der Prozeß c abläuft.

FIG.1

EP 0 424 798 A2

FIG.2

FIG.3